Europäisches Patentamt

European Patent Office

Office européen des brevets

(19)

(11) **EP 1 333 574 A2**

(12) ## EUROPEAN PATENT APPLICATION

(43) Date of publication:
**06.08.2003 Bulletin 2003/32**

(51) Int Cl.7: **H03B 5/12**

(21) Application number: **03100001.1**

(22) Date of filing: **03.01.2003**

(84) Designated Contracting States:
**AT BE BG CH CY CZ DE DK EE ES FI FR GB GR
HU IE IT LI LU MC NL PT SE SI SK TR**
Designated Extension States:
**AL LT LV MK RO**

(30) Priority: **05.02.2002 GB 0202615**

(71) Applicant: **Zarlink Semiconductor Limited
Swindon, Wiltshire SN2 2QW (GB)**

(72) Inventors:
 • **Albon, Richard
  Tavistock, Devon (GB)**
 • **Tingle, Nicholas
  Tavistock, Devon PL19 8BP (GB)**

(74) Representative: **Asquith, Julian Peter
Marks & Clerk,
4220 Nash Court,
Oxford Business Park South
Oxford OX4 2RU (GB)**

(54) **Voltage controlled oscillators**

(57) A voltage controlled oscillator (VCO) is provided which comprises:

 a tank circuit;
 an amplifier comprising a number of switchable amplifier elements (8, 10, 12); and

means for switching each amplifier element (8, 10, 12) on or off depending on the frequency at which the VCO is oscillating, so as to maintain the transconductance of the amplifier elements (8, 10, 12) within certain limits.

Figure 5

EP 1 333 574 A2

## Description

The invention relates to voltage controlled oscillators.

The design of CMOS (Complementary Metal Oxide Silicon) VCOs (Voltage Controlled Oscillators) has proved challenging in terms of providing a low cost solution with reasonable performance on Phase Noise over a broadband radio frequency (RF) frequency range. The use of varactors (devices having a capacitance dependent on voltage) to provide the tuning range has been widely reported yet there are many obstacles to achieving sufficient range just with varactors when also trying to provide a VCO with a low enough phase noise across this range.

The following documents provide general information on the prior art.

1. A general Theory of Phase Noise in Electrical Oscillators - Ali Hajimiri Thomas Lee IEEE SSCCTS Feb 1998.

2. The Design of Low noise Oscillators Ali Hajimiri Thomas Lee published by Kluwer Academic Publishers London.

3. Design Issues in CMOS Differential Oscillators Ali Hajimiri Thomas Lee IEEE SSCCTS May 1999

According to a first aspect of the invention there is provided a voltage controlled oscillator (VCO) as set out in claims 1 to 8.

According to a second aspect of the invention there is provided a voltage controlled oscillator (VCO) as set out in claims 9 and 10. This VCO may also incorporate any of the other features of the VCO of the first aspect of the invention.

Embodiments of the invention will now be described, with reference to the accompanying drawings, in which:

Figure 1 shows a known oscillator which attempts to provide the tuning range and fine resolution needed for broadband RF applications;

Figure 2 shows an equivalent circuit for the circuit of Figure 1;

Figure 3 shows the increase in the amplitude of the output of the oscillator of Figure 1, as frequency increases;

Figure 4 shows an enhancement to the design of Figure 1; and

Figure 5 shows a VCO in accordance with an embodiment of the invention.

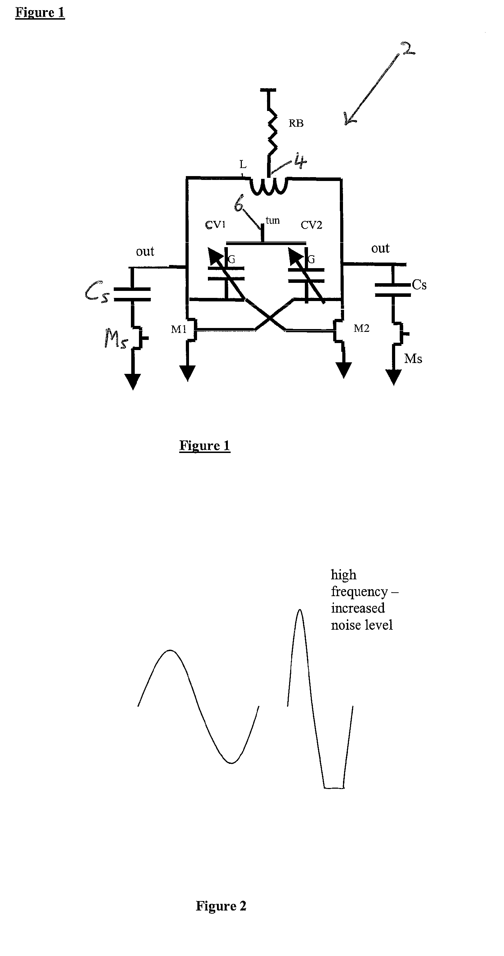

Figure 1 shows a known oscillator 2 which attempts to provide the tuning range and fine resolution needed for broadband RF applications. The use of switch capacitors Cs controlled by switches Ms, and varactors CV1 and CV2, combine to provide a degree of fine and coarse tuning to meet a frequency range from 1 to 2 GHz for example. The switch capacitors Cs are switched in or out to provide coarse tuning, and the varactors CV1 and CV2 are controlled by applying a control voltage to the tune node 6, in order to provide fine tuning. The bias resistor RB at the top provides current limiting into the tank circuit (formed from varactors CV1 and CV2, and an inductor L) through the inductor centre tap 4. The outputs, labelled "out", of the oscillator are taken from either side of the inductor L.

Figure 2 shows an equivalent circuit for the circuit of Figure 1. In order to provide sufficient gain in the nmos amplifier stage (formed from amplifier transistors M1 and M2) to ensure sustained oscillation the negative resistance (Ra) looking into the amplifier has to be at least equal to the equivalent unloaded tank resistance (R). This ratio of resistances is also described as the loop gain (Al) for the oscillator and can be described as:

$$Al = R*gm/2$$

where $-gm/2 = Ra$. and here gm is the transconductance for each amplifier transistor M1, M2.

Generally the loop gain Al needs to be greater than 1 to ensure stable oscillation and usually 2 or more to allow for a margin of safety, allowing for component tolerances and temperature and supply variations.

The tank resistance R in Figure 2 can be thought of as series losses in L and C, where Rc and Rl are the series loss components. It can be shown that the tank loss R is a function of frequency for the oscillator where:

$$R = L/(Rl+Rc)C$$

where the component values L, Rc and Rl are constant and C effectively changes the oscillator frequency. Rearranging Al and R in terms of gm we can say that:

$$gm = 2*Al*C(Rl+Rc)/L$$

so the transconductance gm is proportional to C and signal swing as well as margin for safe oscillation.

So in the device of Figure 1, the transconductance gm of the transistors M1 and M2 will vary with C, and hence the margin for safe oscillation will also vary. When C increases, the frequency of the oscillator and the transconductance gm both decrease, requiring safe oscillation to be determined by the lowest frequency used.

Generally, published VCOs have been implemented with a fixed size of amplifier, which results in the highest frequencies having the highest transconductance gm and hence the largest signal. This results in signal distortion as well as an overshoot of the supply causing reliability problems on transistors due to electrical stress.

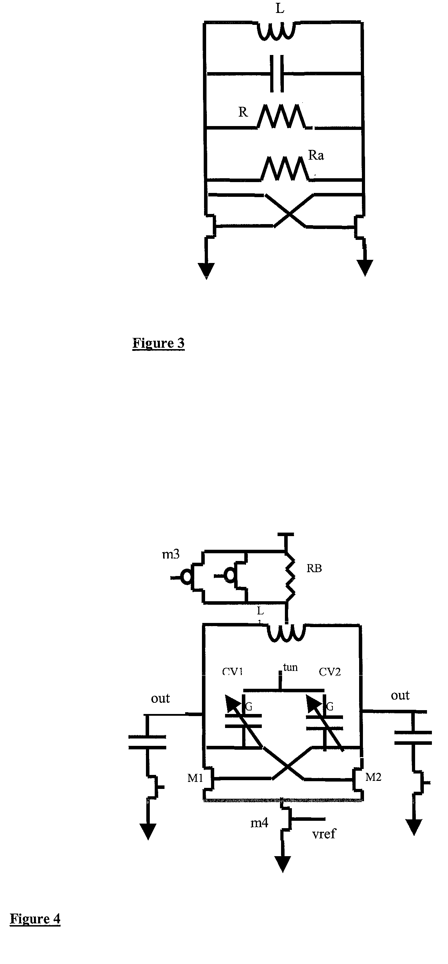

This is illustrated in Figure 3, which shows the increase in the amplitude of the output of the oscillator of Figure 1, as frequency increases. This results in distortion due to the tank signal being clipped (as shown in Figure 3). The distortion generates unwanted harmonics, which cause a dramatic increase in phase noise. A large part of this noise is the flicker noise component which occurs as a result of asymmetries that the distortion causes in the circuit current and voltage waveforms.

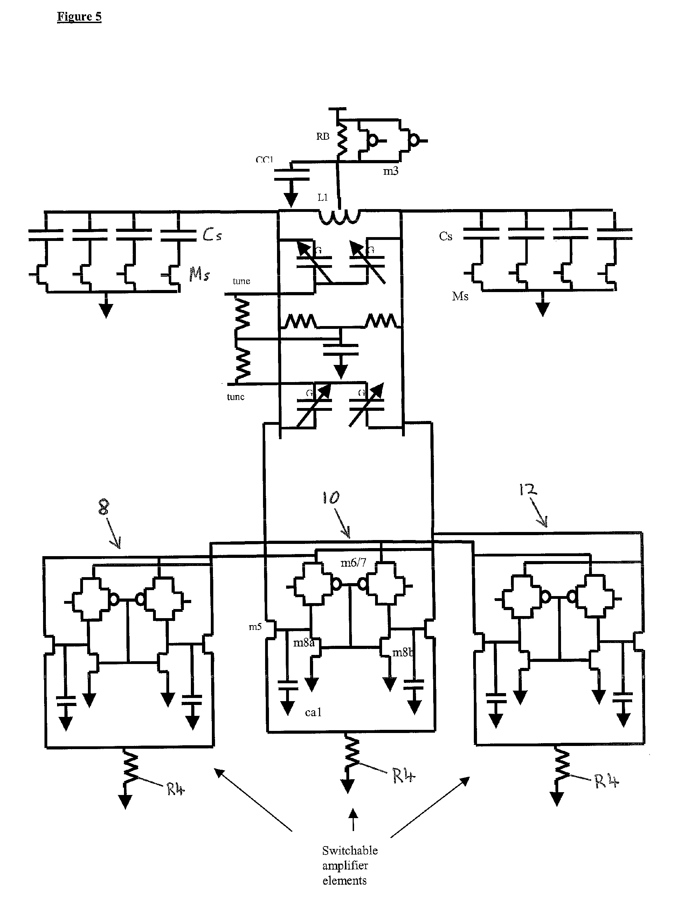

Figure 4 shows an enhancement to the design of Figure 1. A number of transistors M3 are provided in parallel with the bias resistor RB. The transistors M3 can each be varied in order to effectively vary the bias resistance. The use of a variable load to replace the fixed bias resistor RB allows the supply current to be varied at different frequencies. This allows the amplitude of the tank signal to be limited so that it does not exceed the supply voltage, thus preventing clipping of the output voltage and thereby reducing noise and increasing reliability.

Figure 4 also shows the introduction of a tail transistor M4 acting as a current source. This removes the distortion problems caused when the transconductance gm of M1 and M2 is too high, and output signal is clipped. However to make the tail transistor M4 act as a current source requires that its drain and the sources of M1 and M2 to which it is connected, have to be above the transistor threshold voltage (vt) level. With low voltage CMOS circuits it is very difficult to use current sources with oscillators since they introduce relatively large impedance paths to ground or the supply voltage, vdd, and hence can amplify the effects of phase noise in other ways.

If the VCO is properly biased with its signals symmetrical over its region of operation and the tank signal is maximised to achieve the best signal to noise ratio, the flicker noise component which tends to dominate the phase noise, can be greatly reduced.

Figure 5 shows the proposed design which incorporates the use of a tail device and supply biasing around an amplifier and its tank circuit.

The supply biasing uses a number of PMOS devices M3, as in Figure 4. Different devices M3 are enabled according to which switch capacitors Cs are switched on. The inversion of the signal controlling the gate of an M3 device will control the appropriate switch capacitor switch Ms to provide the desired frequency. The devices M3 ensure the tank signal never limits (ie clips) at the supply rail voltage by controlling the current supplied to the tank.

But this does not get around the problem of the loop gain and gm varying with frequency, which causes distortion in the ground path of the signal when the loop gain and gm are excessive at the highest frequencies.

The VCO of Figure 5 is provided with three amplifier elements 8, 10 and 12, each of which can be switched in or out in order to vary the transconductance gm of the amplifier. By making the amplifier change its transconductance gm to compensate for the change in C, the loop gain Al can be optimised to be between 2 to 3 across all frequencies. The amplifier transconductance gm is controlled by the transistors m8a and m8b shown in the switchable amplifier elements 8, 10 and 12 of Figure 5. The loop gain A1 needs to be greater than 2 to ensure safe stable oscillation and less than 3 to avoid excessive non-linear distortion in the ground path.

This involves switching in and out the different amplifier elements 8, 10, 12 in order to provide the right transconductance gm at the appropriate frequency range. The result is an optimised oscillator with minimal distortion, phase noise and power consumed for a maximum signal and hence best signal to noise ratio. The different amplifier elements 8, 10, 12 are switched in or out as different switch capacitors Cs are switched in or out to provide the different frequencies desired. The switch capacitors Cs are switched in and out in pairs (ie one on each side of the tank circuit) so that the circuit remains balanced. The precise relationship between switching of the switch capacitors Cs and switching of the amplifier elements 8, 10 and 12 will vary from circuit to circuit.

The biasing resistors R4 at the bottom of the oscillator do not affect the transconductance gm or loop gain Al, but assist in providing a linear region for the amplifier when its drain to source voltage value approaches its minimum ensuring that the shape of the tank signal does not become asymmetrical. Such asymmetry results in a dramatic increase in flicker noise contribution by the amplifier transistors shown as M1 and M2 in Figure 1 or M8a and M8b in Figure 5. The sizing of R4 to M8a and M8b is important to achieve this.

**Claims**

1. A voltage controlled oscillator (VCO) (2) **characterised by** comprising:

   a tank circuit;
   an amplifier comprising a number of switchable amplifier elements (8, 10, 12); and
   means for switching each amplifier element (8, 10, 12) on or off depending on the frequency at which the VCO is oscillating, so as to maintain the transconductance of the amplifier elements (8, 10, 12) within certain limits.

2. A VCO as claimed in claim 1, which further comprises a number of switch capacitors which are arranged to be switched in or out in order to vary the frequency of the VCO.

3.  A VCO as claimed in claim 1 or 2, wherein said means for switching amplifier elements on or off ensures that said amplifier elements are switched on or off depending on which switch capacitors are switched in or out.

4.  A VCO as claimed in any preceding claim, which further comprises a variable current supply, arranged to be varied in order to control the current into the VCO, so as to reduce variation in the output signal level at different frequencies.

5.  A VCO as claimed in claim 4, wherein said variable current supply comprises a number of PMOS devices.

6.  A VCO as claimed in claim 5, when also dependent on claim 2 or 3, wherein different PMOS devices are enabled depending on which of said switch capacitors are switched in or out.

7.  A VCO as claimed in any preceding claim, wherein each amplifier element is provided with a linear tail component which increases the linearity of the amplifier output, so as to reduce distortion.

8.  A VCO as claimed in any preceding claim, which further comprises a number of varactors for fine tuning the frequency output of the VCO.

9.  A voltage controlled oscillator (VCO) **characterised by** comprising:

    an amplifier;
    a tank circuit; and
    a variable current supply, arranged to be varied in order to control the current into the tank circuit, so as to reduce variation in the output signal level at different frequencies.

10. A VCO as claimed in claim 9, wherein said variable current supply comprises a number of PMOS devices.

**Figure 1**

RB
2
L 4
6 tun
CV1 CV2
out out
G G
Cs Cs
Ms M1 M2 Ms

**Figure 1**

high
frequency –
increased
noise level

**Figure 2**

**Figure 3**

**Figure 4**

Figure 5

Switchable
amplifier
elements